# EUROPÄISCHE PATENTSCHRIFT

(11) **EP 1 751 797 B1**
(45) Veröffentlichungstag und Bekanntmachung des Hinweises auf die Patenterteilung: **31.05.2017**
(21) Anmeldenummer: 05744540.5
(22) Anmeldetag: 17.05.2005
(51) Int. Cl.: H01L 23/525, H02H 5/04

(54) **SCHALTUNGSELEMENT UND VERFAHREN ZUM SICHERN EINER LASTSCHALTUNG**
SWITCHING ELEMENT AND METHOD FOR PROTECTING A CIRCUIT COMPRISING A LOAD
ELEMENT INTERRUPTEUR ET SON PROCEDE DE PROTECTION D'UN CIRCUIT INTERRUPTEUR

(30) Priorität: 24.05.2004 DE 102004025420
(43) Veröffentlichungstag der Anmeldung: 14.02.2007
(73) Patentinhaber: Fraunhofer-Gesellschaft zur Förderung der angewandten Forschung e.V., 80686 München (DE)
(72) Erfinder: BERBERICH, Sven, 91080 Spardorf (DE); MÄRZ, Martin, 90491 Nürnberg (DE)
(74) Vertreter: Stöckeler, Ferdinand
(86) Internationale Anmeldenummer: PCT/EP2005/005360
(87) Internationale Veröffentlichungsnummer: WO 2005/117113

(56) Entgegenhaltungen:
- US-A- 5 003 371
- US-A1- 2002 070 393
- US-B1- 6 331 763

## Beschreibung

Die vorliegende Erfindung bezieht sich auf ein Schaltungselement und ein Verfahren zum Sichern einer Lastschaltung.

Eine in der Elektronik gerade unter Sicherheitsaspekten immer bedeutender werdende Aufgabenstellung, besteht darin, wie sich einzelne Bauelemente oder Schaltungsteile im Fehlerfall gezielt, dauerhaft und möglichst kostengünstig stilllegen lassen, um so größere Folgeschäden zu verhindern.

Anhand zweier Ausführungsbeispiele gemäß dem Stand der Technik soll dieses Thema näher beleuchtet werden.

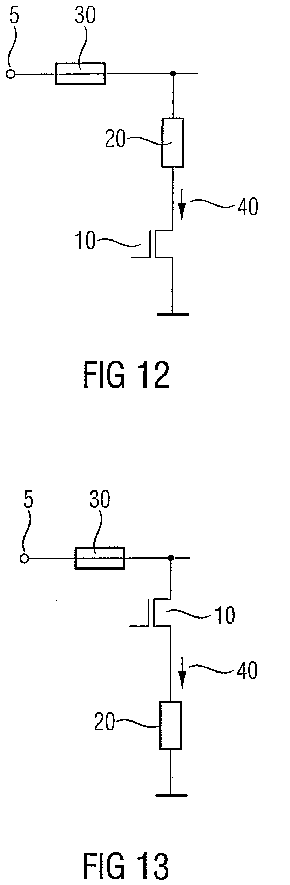

Leistungshalbleiter werden heute im großen Umfang zum Schalten elektrischer Lasten, wie Lampen, Ventile, Motoren, Heizungselemente usw. eingesetzt, in zunehmenden Maße aber auch im Bereich des Leistungsmanagements zum Abschalten einzelner Schaltungsteile, z. B. um den Energieverbrauch batteriebetriebener Geräte zu reduzieren. Die beiden typischen Anordnungen von Schalter und Last sind in Fig. 12 und Fig. 13 dargestellt.

Fig. 12 zeigt einen sog. Lowside-Schalter. Dargestellt sind ein Spannungsanschluß 5, ein Schalter 10, der hier beispielsweise als Feldeffekttransistor ausgeführt ist, eine Last 20, eine Schmelzsicherung 30 und einen Verlauf des Laststroms 40.

Da der Schalter 10 in der Plus-Leitung zur Masse-Leitung liegt spricht man von einem Lowside-Schalter. Wichtig für eine geringe Verlustleistung im Schalter 10 ist dabei, dass der Schalter im Ein-Zustand einen sehr viel geringeren elektrischen Widerstand als die Last 20 aufweist.

Fig. 13 zeigt einen Highside-Schalter. Der Schalter 10 liegt dabei in der Plus-Leitung zur Last 20. Dies ist der einzige Unterschied gegenüber dem in Fig. 12 dargestellten Lowside-Schalter.

Auch für den Highside-Schalter gilt, dass die Verlustleistung in dem Schalter 10 gering sein sollte gegenüber der Leistung im elektrischen Widerstand, der hier die Last 20 bildet, das bedeutet, dass der Widerstand des Schalters 10 gering sein sollte gegenüber dem Widerstand der Last 20.

Für diese Spannungsanwendungen haben sich als elektronische Schalter Leistungs-MOSFET weitgehend durchgesetzt. Eine in den letzten Jahren sehr rasante Entwicklung in Richtung immer niedrigerer spezifischer Durchlasswiderstände, die sich aus der Kalkulation R_{ds(on)}xA, wobei R_{ds(on)} den spezifischen Durchlasswiderstand darstellt, und A die Fläche symbolisiert, hat es dabei ermöglicht, dass heute Ströme von vielen Ampere mit direkt auf der Leiterplatte montierten Halbleiterschaltern ohne spezielle Kühlmaßnahmen beherrschbar sind.

Ein Problem entsteht jedoch, wenn durch Fehler im Halbleiterschalter oder in dessen Ansteuerung kein vollständiges Einschalten mehr erfolgt. Der Schalter erreicht dann nicht mehr seinen niedrigen nominellen Durchlasswiderstand, so dass auch die Verlustleistung im Schalter sehr stark ansteigt. Im schlimmsten Fall der Leistungsanpassung, das heißt, wenn der Durchlasswiderstand des Schalters in den Bereich des Werts des Lastwiderstands kommt, kann die Verlustleistung im Schalter bis zu einem Viertel der Lastnennleistung erreichen. Ein Beispiel kann dies verdeutlichen:
In einem Leistungs-MOSFET mit einem Durchlasswiderstand von 10 mΩ, der als Schalter für eine Last von 120 Watt an 12 Volt eingesetzt wird, entsteht im Nennbetrieb eine Verlustleistung von 1 Watt. Auf diese Verlustleistung wird man die Kühlung des MOSFETs in einer konkreten Schaltung auslegen.

Steigt jetzt jedoch in dem Ausführungsbeispiel des Stands der Technik durch einen Fehler, der beispielsweise in der Ansteuerung auftreten kann, der Durchlaßwiderstand an, so kann die Verlustleistung im Schalter Werte von bis zu 40 Watt erreichen. Bei einer auf 1 Watt ausgelegten Kühlung führt dies sehr schnell zu gefährlich hohen Temperaturen bis hin zu einer Brandgefährdung z. B. der Leiterplatte. Übliche Schutzelemente wie Schmelzsicherungen 30 können diesen Fehlerfall nicht abfangen, da ja keinerlei Überstrom auftritt.

Die Last 20 begrenzt den Strom 40 immer auf einen Wert, der den Nennbetriebsstrom nicht übersteigt. Auch beliebige Überwachungsschaltungen, die diesen Fehler detektieren, würden nicht weiterhelfen, da ja bei jedem angenommenen Defekt in der Ansteuerschaltung oder im Leistungsschalter kein Abschalten des Laststroms mittels des Leistungsschalters mehr möglich wäre.

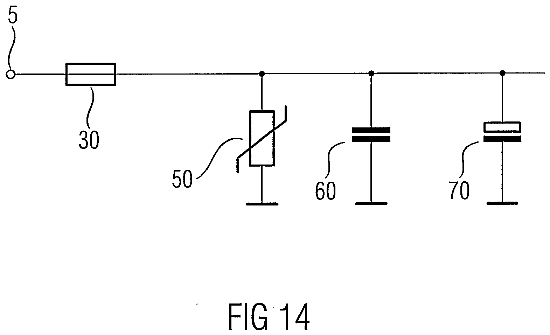

Fig. 14 erläutert ein weiteres Ausführungsbeispiel gemäß dem Stand der Technik. Dargestellt sind der Spannungsanschluß 5, die Schmelzsicherung 30, ein Varistor 50, ein Keramik-Vielschichtkondensator 60 und ein Tantal-Elektrolytkondensator 70. Fig. 14 zeigt eine Reihenschaltung aus der Schmelzsicherung 30 mit einer Parallelschaltung, die den Varistor 50, den Keramik-Vielschichtkondensator 60 und den Tantal-Elektrolytkondensator 70 umfaßt.

Die sicherheitskritischen.Bauelemente, wie der Varistor 50, der Keramik-Vielschichtkondensator 60 und der Tantalelektrolyt-Kondensator 70 liegen dabei über die Schmelzsicherung 30 direkt an der Versorgungsspannung 5 an. Im funktionstüchtigen Zustand besitzen diese Bauelemente bei der Nennbetriebsspannung einen vernachlässigbaren Leckstrom und damit eine vernachlässigbare statische Verlustleistung. Steigt jedoch der Leckstrom im Fehlerfall an, oder tritt speziell bei Keramik-Vielschichtkondensatoren aufgrund von mechanischem Stress ein Plattenschluss auf, so steigt die statische Verlustleistung sehr stark an und kann zu einer extremen Überhitzung des Bauelements führen.

Gerade bei größeren zentral abgesicherten Baugruppen besteht dabei das Problem, dass der in diesem Fehlerfall auftretende Strom zwar ausreicht, um lokal extreme Übertemperaturen mit Brandgefahr zu erzeugen, der Strom andererseits aber nicht hoch genug ansteigt, um das zentrale Sicherungselement, das hier in der Schmelzsicherung 30 implementiert ist, zum Auslösen zu bringen. Der Varistor 50, der Keramik-Vielschichtkondensator 60 und der Tantal-Elektrolytkondensator 70 stehen in diesem Ausführungsbeispiel nur symbolisch für eine Reihe weiterer Bauelemente, die am Lebensdauerende bei Überlastung oder vorzeitigem Ausfall mit hoher Wahrscheinlichkeit niederohmig werden. Alle diese Bauelemente stellen in Bezug auf oben genannten Sachverhalt ein Risiko dar.

In diesem Zusammenhang wird wieder ein Nachteil des Standes der Technik deutlich, dass hier ein fremd aktivierbares Sicherungselement fehlt, das es ermöglichen würde, einzelne sicherheitskritische Bauelemente gezielt von elektrischer Spannung zu trennen. In zahlreichen Fällen könnte damit zumindest eine Notlauffunktionalität einer Baugruppe aufrechterhalten werden.

Zwar lassen sich zur Absicherung gegen Schäden durch zu hohe Ströme nach dem Stand der Technik überwiegend Schmelzsicherungen einsetzen. Diese sind auch in unterschiedlichsten Bauformen und Auslösecharakteristiken erhältlich. Zugleich gibt es sogar als Überstromschutz auch Kaltleiter, wie beispielsweise PTC-Elemente, die auf Keramik- oder Polymerbasis, wie beispielsweise ein Poly-Switch^{™}, die breite Anwendung finden. Tritt jedoch, wie oben beschrieben, ein derart gelagerter Fehlerfall ein, dass kein Überstrom auftritt, so sind diese Sicherungen als Schutzelemente ungeeignet. Auch zur Absicherung sicherheitskritischer Bauelemente sind diese Sicherungen aufgrund ihrer Baugröße, Kosten und Auslösecharakteristiken nicht geeignet. Bei Kondensatoren beispielsweise kann der Betriebswechselstrom deutlich über dem zu fordernden Auslöse-Gleichstrom liegen, eine Anforderung, die mit einer klassischen Schmelzsicherung nicht erfüllbar ist.

Daneben werden in Ausführungsbeispielen gemäß dem Stand der Technik auch Temperatursensoren eingesetzt, um Schaltungen gegenüber Temperaturen zu überwachen. Aber auch diese Art der Überwachung kann im beschriebenen Fall eines defekten, nicht mehr steuerbaren Halbleiters keinen Schutz bieten. Das Erkennen einer Übertemperatur nützt hier nichts, da der Stromfluss durch Eingriff in die Steuerspannung des defekten Schalters ja nicht mehr unterbrochen werden kann. Auch dies stellt ein hohes Risiko für die zu schützenden Baugruppen dar.

Eine weitere Variante gemäß einem Ausführungsbeispiel des Standes der Technik besteht im Einsatz eines Crowbar-Schalters. Ein Crowbar-Schalter ist ein leistungsfähiger Kurzschlussschalter, der in der Lage ist, eine vorhandene Zentralsicherung auszulösen. Aufgrund der hohen Kosten und des erforderlichen Platzbedarfs sind Crowbar-Lösungen in Ausführungsbeispielen gemäß dem Stand der Technik nicht für dezentrale Schutzmaßnahmen geeignet. Ein zentraler Crowbar beschränkt die möglichen Einsatzfelder sehr stark, da es in vielen Anwendungen nicht tolerierbar ist, im Fehlerfall das Gesamtsystem anstelle nur eines einzigen Laststrompfads stillzulegen.

Die US 5003371 lehrt ein Schaltungselement mit einer Sicherung, einem Eingangspin und einem Ausgangspin. Der Eingangspin und der Ausgangspin sind über dotierte Zonen miteinander verbunden. Die dotierten Zonen sind dabei so angeordnet, dass sich ein Thyristor und ein Feldeffekttransisor ausbilden. Der Thyristor kann dabei durch ein positives Signal an einem Gate des Feldeffekttransistors gezündet werden. Nach einem Zünden des Thristors veranlasst der Thyristor ein Durchschmelzen der Sicherung.

Die US 5757599 lehrt ein Sicherungselement in einer Schaltungsvorrichtung. Das Sicherungselement ist dabei zu der Schaltungsvorrichtung parallel geschaltet. Falls die Betriebsparameter der Schaltungsvorrichtung überschritten werden, erzeugt das Sicherungselement durch einen irreversiblen Kurzschluss in einem Thyristor einen Kurzschluss der Schaltungsvorrichtung.

Die DE 19805785 C1 lehrt ein Leistungshalbleitermodul, in dem ein Leistungshalbleiterbauelement über Ausgangsleitungen elektrisch leitend verbunden ist. Das Leistungshalbleitermodul weist Unterbrechungsmittel auf, die falls eine vorgeschriebene Betriebstemperaturschwelle überschritten wird, die Ausgangsleitungen irreversibel unterbrechen. Das Unterbrechungsmittel ist dabei durch eine volumenerweiternde oder explodierende Charakteristik gekennzeichnet.

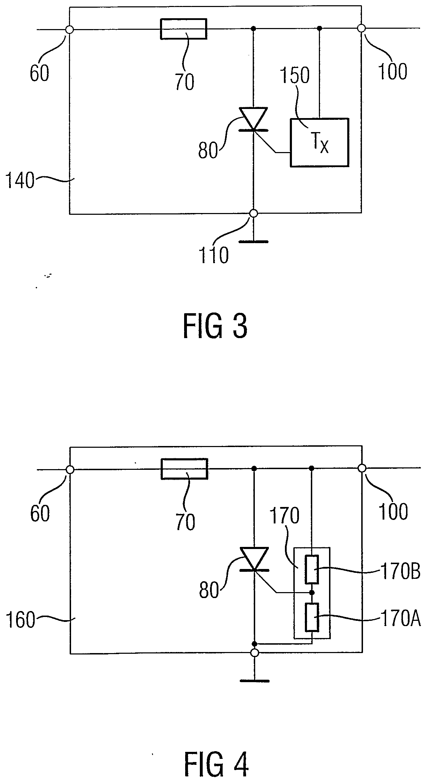

Die US 2002/0070393 lehrt ein Sicherungselement, wie es in Fig. 3 derselben gezeigt ist. In einem Zwischendielektrikum 10 ist eine Ausnehmung 12 gebildet, so dass eine über den Dielektrikum 10 gebildete Barrierenschicht 30 im Bereich der Ausnehmung unterbrochen ist. Über der Barrierenschicht 30 ist eine Leiterbahn 40 angeordnet, die die Ausnehmung 12 füllt, siehe Abschnitt [0030] des Dokuments D2. Eine durch einen Unterschnitt 20 bewirkte Unterbrechung 34 erzeugt eine Schwachstelle 44 in der Leiterbahn 40, wobei aufgrund der Unterbrechung in der Barrierenschicht 30 ferner eine elektrische Schwachstelle erzeugt wird und somit findet gemäß dem Dokument D2 bei höheren Stromdichten eine Unterbrechung wahrscheinlich in diesem Bereich statt. Der vorliegenden Erfindung liegt die Aufgabe zugrunde, ein Schaltungselement zum Sichern einer Lastschaltung und ein Verfahren zum Sichern einer Lastschaltung, die ein sicheres Unterbrechen eines Strompfads ermöglichen, zu schaffen.

Diese Aufgabe wird durch ein Schaltungselement gemäß Anspruch 1 und ein Verfahren gemäß Anspruch 15 gelöst.

Die vorliegende Erfindung schafft ein Schaltungselement mit einem Signaleingang zum Anlegen eines Signals, einem Signalausgang, einem Signalpfad, der den Signaleingang mit dem Signalausgang verbindet, und eine Unterbrechungseinrichtung zum irreversiblen Unterbrechen des Signalpfads auf einen Empfang eines Steuersignals an derselben hin.

Darüber hinaus schafft die vorliegende Erfindung ein Verfahren zum Sichern einer Lastschaltung, das ein Empfangen eines Steuersignals und ein irreversibles Unterbrechen eines Signalpfads zwischen einem Eingang und einem Ausgang eines Schaltungselements auf den Empfang des Steuersignals hin umfasst.

Der vorliegenden Erfindung liegt die Erkenntnis zugrunde, dass einem Strom auf einem Signalpfad zwischen einem Eingang und einem Ausgang eines Schaltungselements auf den Empfang eines Steuersignals ein weiterer Strom so überlagert werden kann, dass der Signalpfad unterbrochen wird.

Ein Schaltungselement bzw. Sicherungselement gemäß der vorliegenden Erfindung weist erhebliche Vorteile auf. Es verbindet in einzigartiger Weise den Vorteil einer Schmelzsicherung, die ja über einen sehr niedrigen Widerstand der intakten Sicherungsstrecke verfügt, mit der Steuerbarkeit von Halbleiterschaltern. Der Einfügewiderstand in einem Ausführungsbeispiel der vorliegenden Erfindung lässt sich vergleichsweise einfach auf Werte von wenigen mΩ und darunter drücken, Werte die damit bei vergleichbarer Chipfläche und vergleichbaren Kosten mit keiner heute bekannten abschaltbaren Halbleiterstruktur auch nur annähernd erreichbar sind. Durch eine auf dem Schaltungselement bzw. Sicherungselement integrierte stromverstärkende Crowbar-Struktur bzw. Schutzschaltungsstruktur ist ein sehr einfaches gesteuertes Auslösen eines Sicherungsschaltungselementes bzw. einer Sicherung möglich.

Bei einer vorteilhaften Auslegung gemäß einem Ausführungsbeispiel der vorliegenden Erfindung ist sogar der Steuereingang bezüglich Eingangswiderstand und Spannungspegel Mikroprozessor-kompatibel. Der besondere Vorteil liegt dabei, dass mittels des Mikroprozessors auch nur dedizierte Teile einer Schaltung stillgelegt werden können, wobei eine Notlauffunktionalität einer zu schützenden Schaltung weiter aufrecht erhalten werden kann.
In einem weiteren Ausführungsbeispiel gemäß der vorliegenden Erfindung kann auch ein temperaturabhängiges, sich selbst auslösendes Schaltungselement zum Sichern einer Lastschaltung räumlich nahe an ein zu schützendes Bauelement, wie in einem Ausführungsbeispiel gemäß der vorliegenden Erfindung, beispielsweise einem Schalter, angebracht werden. Erreicht hier, bei Vorliegen eines Fehlers, die Temperatur an dem Schaltungselement zum Sichern der Lastschaltung die Auslösetemperatur, so trennt das Schaltungselement zum Sichern der Lastschaltung bzw. Sicherungselement den Strompfad sicher und dauerhaft auf, und vermeidet dadurch weitergehende Schäden, wie beispielweise besonders Brandschäden, im System.

Die große Flexibilität der vorliegenden Erfindung zeigt sich aber auch darin, dass in weiteren Ausführungsbeispielen der vorliegenden Erfindung die Schaltungselemente zum Schutz einer Lastschaltung von einer Vielzahl an Überwachungsschaltungen aktiviert werden können. Beispielsweise kann eine Überwachungsschaltung dazu direkt durch Strom- oder Spannungsmessungen oder indirekt über Infrarot-Wärmestrahlungs- bzw. IR-Wärmestrahlungs- oder TemperaturSensoren Fehlerzustände im System detektieren, und anschließend durch ein Ansteuern des Sicherungselements bzw. des Schaltungselements zum Sichern der Lastschaltung einzelne Laststrompfade, Kondensatorblöcke oder andere sicherheitskritische Schaltungsteile, wie in Ausführungsbeispielen gemäß der vorliegenden Erfindung implementierbar, zuverlässig und dauerhaft von der Spannungsversorgung trennen.

Hier zeigt sich auch in einem Ausführungsbeispiel gemäß der vorliegenden Erfindung die große Flexibilität der Schaltungselemente zum Sichern einer Lastschaltung gemäß der vorliegenden Erfindung. In den Überwachungsschaltungen können nämlich auch vorteilhafterweise Mikroprozessoren zum Einsatz kommen, die dann noch Plausibilitätsprüfungen der Fehlersignale vornehmen und damit die Gefahr von Fehlerauslösungen reduzieren bzw. minimieren. Bei einer geeigneten Auslegung gemäß einem Ausführungsbeispiel der vorliegenden Erfindung sind damit auch intelligente Reaktionsstrategien auf Fehler möglich, wie beispielsweise eine Leistungsreduzierung in einem Netzteil nach Abschalten einzelner defekter Siebkondensatoren oder sogar der funktionelle Ersatz eines ausgefallenen Rücklichtkanals von Kraftfahrzeugen durch ein gedämmtes Bremslicht, was in einem weiteren Ausführungsbeispiel gemäß der vorliegenden Erfindung ermöglicht ist.

Gleichzeitig lassen sich durch die vorliegende Erfindung die Kosten für den Betrieb eines Gesamtsystems, von dem Teile durch ein Schaltungselement gemäß der vorliegenden Erfindung geschützt werden, sparen. Vorteilhafterweise lässt sich in einem Ausführungsbeispiel der vorliegenden Erfindung beispielsweise ein Überspannungsschutz besonders hochwertiger und teurer Schaltungselemente bzw. Schaltungsteile realisieren. Wie eine klassische Schmelzsicherung gegen Überströme schützt hierbei ein Schaltungselement zum Sichern einer Lastschaltung gemäß der vorliegenden Erfindung gegen Überspannungsschäden eben nur eines ganz dedizierten Schaltungsteils, der besonders teuer ist. Anschließend ist nach dem Ansprechen wie bei einer klassischen Schmelzsicherung ein Austauschen des Schaltungselements zum Sichern der Lastschaltung erforderlich, um die zu schützende, besonders hochwertige dedizierte Teilschalung wieder in Betrieb zu nehmen.

Darüber hinaus kann in einem weiteren Ausführungsbeispiel gemäß der vorliegenden Erfindung das Schaltungselement zum Sichern einer Lastschaltung sogar auf einem Chip integriert sein, und vorbestimmte Teile der Schaltungsstruktur auf diesem Chip schützen, während andere Teile der Schaltungsstruktur auf dem Chip eine Notlauffunktionalität sicherstellen. Dies unterstreicht die umfangreiche Einsetzbarkeit der vorliegenden Erfindung in der integrierten Schaltungsstrukturtechnik.
Zusätzlich kann das Sicherungselement gemäß der vorliegenden Erfindung sowohl als diskretes elektronisches Bauelement realisiert sein, als auch in einer integrierten Schaltung integriert sein. Da das Sicherungselement in einem Ausführungsbeispiel gemäß der vorliegenden Erfindung eben auf einem Chip integriert werden kann, der weitere Schaltungsstrukturen umfasst, lässt sich hierdurch auch die Anzahl der Komponenten in einem Gesamtsystem reduzieren, wodurch sich die Kosten reduzieren lassen.

Ein weiterer Vorteil der vorliegenden Erfindung, besteht in der Flexibilität der Auslösemechanismen, mit denen ein Sicherungselement gemäß der vorliegenden Erfindung aktiviert werden kann. So kann dies entweder über einen am Steuereingang liegendes Signal erfolgen, oder unter Auswertung bestimmter physikalischer Größen wie beispielsweise Umgebungstemperatur oder Versorgungsspannung.

Darüber hinaus kann ein Sicherungselement gemäß der vorliegenden Erfindung monolithisch in Silizium realisiert werden, was zu entsprechend kleinen geometrischen Abmessungen führt und eine kostengünstige Fertigung in hohen Stückzahlen ermöglicht.

Bevorzugte Ausführungsbeispiele der vorliegenden Erfindung werden nachfolgend Bezug nehmend auf die beiliegenden Zeichnungen näher erläutert. Es zeigen:

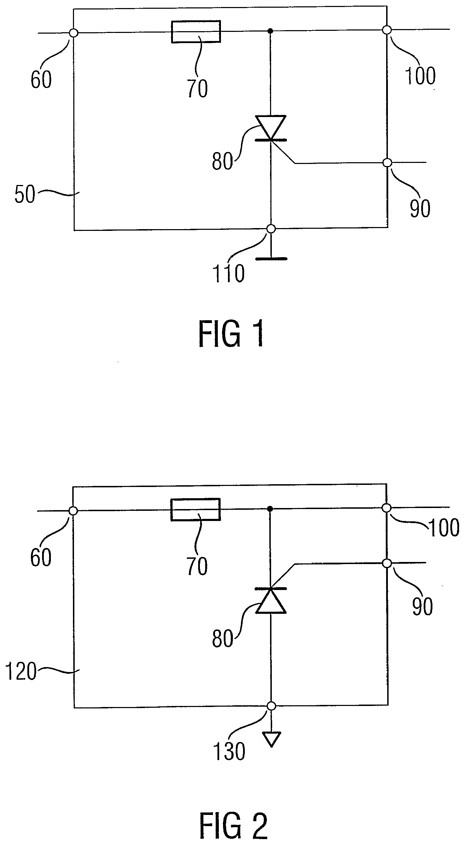

- Fig. 1: ein Schaltungselement gemäß einem Ausführungsbeispiel der vorliegenden Erfindung;
- Fig. 2: ein weiteres Schaltungselement gemäß der vorliegenden Erfindung;
- Fig. 3: ein Schaltungselement gemäß der vorliegenden Erfindung mit einem Temperatursensor;
- Fig. 4: ein Schaltungselement gemäß der vorliegenden Erfindung, das über ein Eingangssignal einer Spannungsteilerschaltung ausgelöst wird;

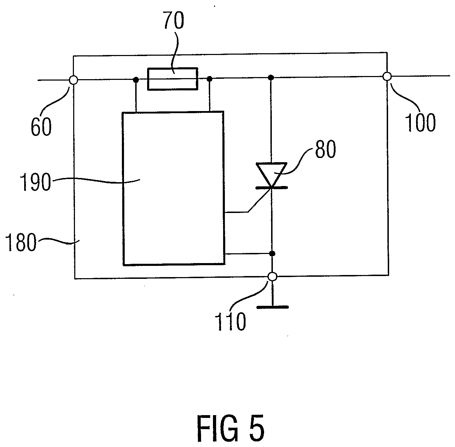

- Fig. 5: ein Schaltungselement gemäß einem Ausführungsbeispiel der vorliegenden Erfindung, das bei Überschreiten einer vordefinierten Stromschwelle ausgelöst wird;

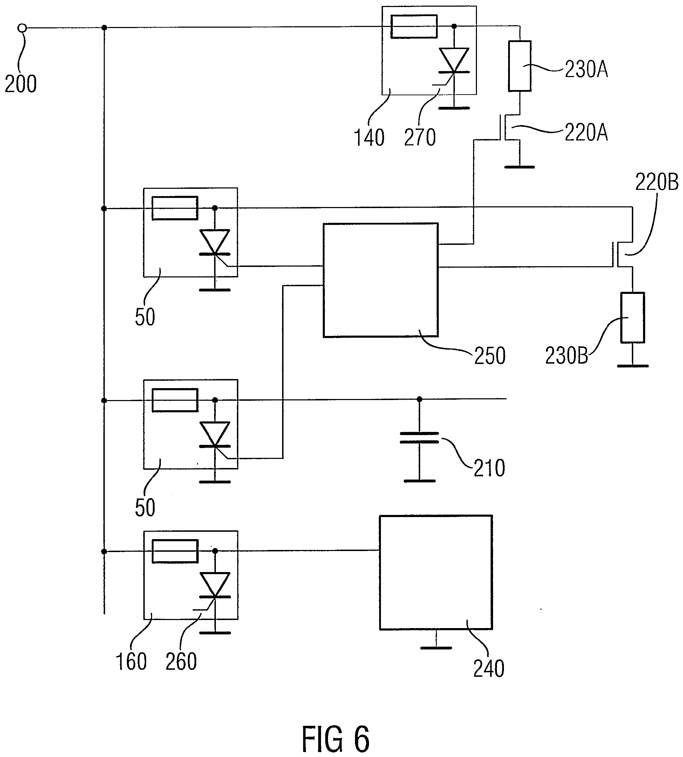

- Fig. 6: eine Schaltung, die durch Schaltungselemente gemäß der vorliegenden Erfindung geschützt wird;

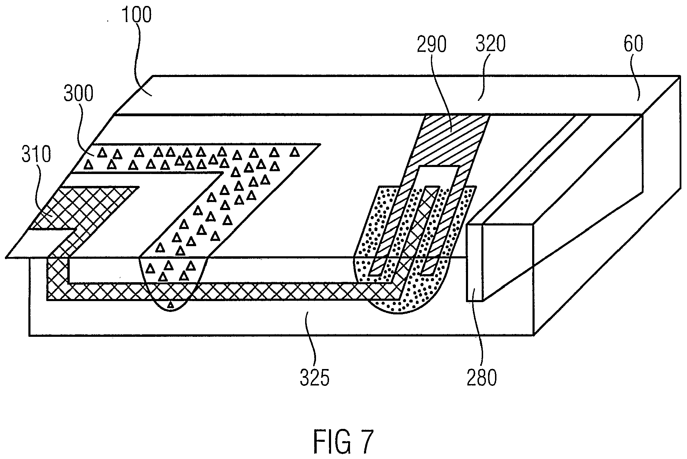

- Fig. 7: Implementierung eines Ausführungsbeispiels gemäß der vorliegenden Erfindung auf einem Halbleitersubstrat;

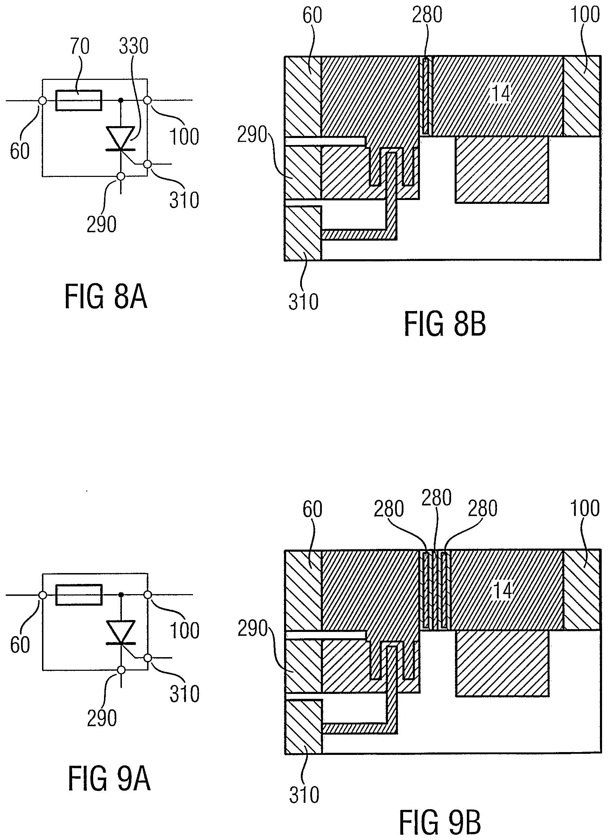

- Fig. 8a 8b: ein Ausführungsbeispiel gemäß der vorliegenden Erfindung und Implementierung desselben auf einem Halbleitersubstrat;
- Fig. 9a, 9b: weitere Ausführungsvariante des in Fig. 8a, 8b gezeigten Ausführungsbeispiel gemäß der vorliegenden Erfindung bezüglich der Implementierung auf dem Halbleitersubstrat;

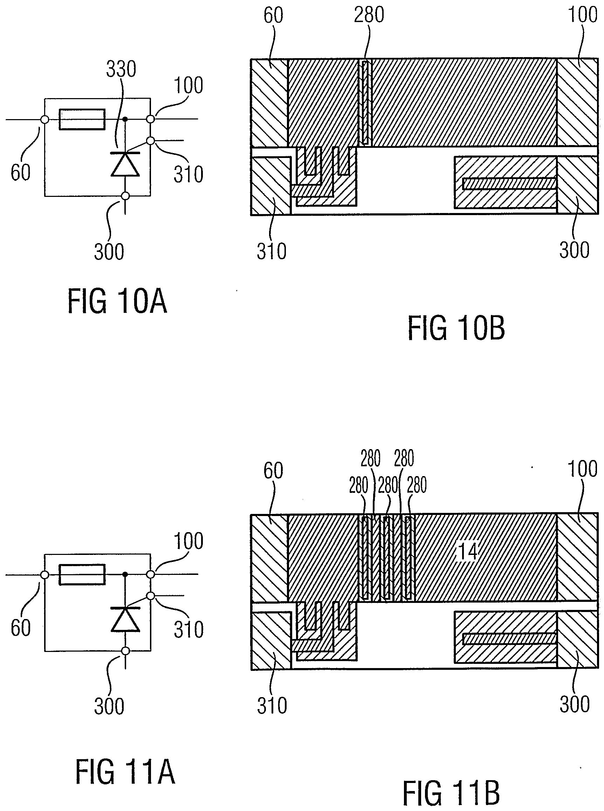

- Fig. 10a, 10b: ein weiteres Ausführungsbeispiel gemäß der vorliegenden Erfindung und dessen Implementierung auf einem Halbleitersubstrat;
- Fig. 11a, 11b: eine weitere Implementierungsform des Ausführungsbeispiels aus Fig. 10a, 10b auf einem Halbleitersubstrat;
- Fig. 12: Einsatz einer Schmelzsicherung als LowsideSchalter in einer Schaltung gemäß dem Stand der Technik;
- Fig. 13: Einsatz einer Schmelzsicherung als HighsideSchalter in einer Schaltung gemäß dem Sand der Technik; und
- Fig. 14: Sicherungsschaltung in einem Ausführungsbeispiel gemäß dem Stand der Technik.

Fig. 1 zeigt ein Sicherungsschaltungselement gegenüber Masse 50, das gemäß einem Ausführungsbeispiel der vorliegenden Erfindung implementiert ist. Es umfasst einen Eingang 60, ein Unterbrechungselement 70, ein Auslöseelement 80, ein Ansteuersignal 90, einen Ausgang 100 und einen Masseanschluss 110. Der Eingang 60 ist über das Unterbrechungselement 70 mit dem Ausgang 100 verbunden, wobei der Ausgang 100 über das Auslöseelement 80 an den Masseanschluss 110 angeschlossen ist. Der Ansteuersignaleingang 90 weist eine leitende Verbindung mit dem Auslöseelement 80 auf.

Das Unterbrechungselement 70 trennt den Signalpfad zwischen dem Eingang 60 und dem Ausgang 100 auf, wenn das Auslöseelement 80 entsprechend niederohmig wird, und damit zu einem hohen Strom über das Unterbrechungselement 70 führt. Das Verhalten des Auslöseelements 80 wird über ein Steuersignal an dem Ansteuersignaleingang 90, gesteuert. Somit ist zwischen den Leistungsanschlüssen 60 und 100 mit dem Unterbrechungselement 70 eine Sicherungsstrecke eingefügt. Das Auslöseelement 80 kann beispielsweise als elektronischer Schalter zwischen dem lastseitigen Leistungsanschluss bzw. Ausgang 100 und dem Masseanschluss bzw. weiteren Leistungsanschluss 110 ausgeführt sein, und ein Auftrennen der Sicherungsstrecke zwischen dem Eingang 60 und dem Ausgang 100 und damit eine sichere Unterbrechung des Strompfads ermöglichen.
Liegt an dem Ansteuersignaleingang 90 ein Steuersignal an, so verringert sich der Widerstand des Auslöseelements 80, was zu einer Erhöhung des Stroms durch das Unterbrechungselement 70 führt. Das Unterbrechungselement 70 erhitzt sich durch diese Stromzunahme anschließend solange, bis es sich durch diese Erhitzung selbst zerstört.

Als Schalter bzw. Auslöseelement 80 können beispielsweise eine Thyristor-Struktur zum Einsatz kommen oder aber auch Bipolartransistor-Strukturen, sowie eine DarlingtonSchaltung oder auch MOSFET- oder IGBT-Strukturen und sogar beliebige andere stromverstärkende Halbleiterstrukturen.

In diesem Ausführungsbeispiel der vorliegenden Erfindung ist der Masseanschluss 110 mit einem Spannungspotential verbunden, das mindestens um wenige Volt, maximal aber um etwas weniger als die Durchbruchspannung des Schalters 80 unterhalb des Potentials an dem Eingang 60 liegt. Die Spannung zwischen dem Eingang 60 und dem Masseanschluss 110 muss dabei dynamisch so stabil sein, dass ein Auslösen auf der Sicherungsstrecke in dem Unterbrechungselement 70 möglich ist. Vorteilhafterweise ist dabei in diesem Ausführungsbeispiel der vorliegenden Erfindung der Masseanschluss 110 mit der Schaltungsmasse bzw. GND oder ground verbunden.

In Fig. 2 ist ein weiteres Ausführungsbeispiel gemäß der vorliegenden Erfindung dargestellt. Das hier gezeigte Sicherungsschaltungselement 120 gegenüber Versorgungsspannung unterscheidet sich von dem in Fig. 1 gezeigten Ausführungsbeispiel dadurch, dass das Auslöseelement 80 zwischen dem Ausgang 100 und dem Versorgungsspannungsanschluss 130 liegt. Hierdurch ist selbstverständlich auch die Polung des Auslöseelements 80 entsprechend anzupassen.

Fig. 3 stellt ein weiteres Ausführungsbeispiel gemäß der vorliegenden Erfindung dar, das ein Temperatursicherungsschaltungselement 140 aufweist. Hierbei erfolgt die Ansteuerung des Auslöseelements 80 über einen Temperatursensor 150, der an dem Ausgang 100 anliegt, im Gegensatz zu dem Ausführungsbeispiel, das in Fig. 1 gezeigt ist. Abhängig vom Widerstand des Temperatursensors 150 verändert sich die Spannung des Ansteuersignals an dem Auslöseelement 80, und führt bei Überschreiten einer bestimmten Schwelle dazu, dass das Auslöseelement 80 das Unterbrechungselement 70 aktiviert. Als Temperatursensor kann beispielsweise eine pn-Diodenstrecke zum Einsatz kommen, oder auch ein Thyristor als Schalter bzw. Auslöseelement 80 eingesetzt werden, wobei der Thyristor so dimensioniert werden kann, dass bei einer geforderten Auslösetemperatur ein selbstständiges Zünden, was einem sog. Überkopfzünden entspricht, eintritt. I

Fig. 4 zeigt ein weiteres Ausführungsbeispiel gemäß der vorliegenden Erfindung, die hier in einem Überspannungsschutzelement 160 eingesetzt wird. Der Temperatursensor 150 aus dem Ausführungsbeispiel in Fig. 3 ist dabei durch eine Spannungsteilerschaltung 170, die einen ersten Serienwiderstand 170a und einen zweiten Serienwiderstand 170b umfasst, ersetzt. Die Spannung wird dabei an einem Punkt zwischen den Serienwiderständen 170a und 170b abgegriffen.

Hierbei wird die Ausgangsspannung an dem Ausgang 100 überwacht und bei Überschreitung einer maximalen Spannung zwischen dem Ausgang 100 und dem Masseanschluss 110 wird über das Ansteuersignal das Auslöseelement 80 aktiviert, das das Unterbrechungselement 70 dazu veranlasst, den Signalpfad bzw. die Sicherungsstrecke zwischen dem Eingang 60 und dem Ausgang 100 zu unterbrechen.

Fig. 5 zeigt ein weiteres Ausführungsbeispiel der vorliegenden Erfindung, das hier als Überstromschutzelement 180 eingesetzt wird. Statt wie bei dem Überspannungsschutzelement 160 in Fig. 4 erfolgt hier die Ansteuerung des Auslöseelements 80 über einen Spannungsmesser 190. Der Spannungsmesser 190 bestimmt dabei eine an dem Unterbrechungselement 70 anliegende Spannung, und nutzt hierbei den Umstand, dass die an dem Unterbrechungselement 70 abfallende Spannung proportional zu dem in dem Unterbrechungselement 70 fließenden Strom ist. Somit wird ein Spannungsabfall an der Sicherungsstrecke bzw. dem Unterbrechungselement 70 ermittelt, was bei intakter Sicherungsstrecke als Strommesswiderstand dient, und anschließend ausgewertet.

Überschreitet nun der Stromwert einen voreingestellten Stromwert, so erfolgt ein Ansteuern des Auslöseelements 80 und damit ein Auslösen der Sicherungsstrecke bzw. des Unterbrechungselements 70. Wenn der Strom einen voreingestellten Stromwert überschreitet, so verringert sich der Widerstand des Auslöseelements 80, was zu einer Erhöhung des Stroms durch das Unterbrechungselement 70 führt. Das Unterbrechungselement 70 erhitzt sich durch diese Stromzunahme anschließend solange, bis es sich durch diese Erhitzung selbst zerstört.

Durch Hinterlegung entsprechender Charakteristiken in der Auswerte- und Ansteuerschaltung bzw. dem Spannungsmesser 190 können bei diesem aktiven Schaltungselement zur Sicherung nahezu beliebige Auslösecharakteristiken realisiert werden.

Fig. 6 erläutert wie Ausführungsbeispiele der vorliegenden Erfindung in einem Gerät eingesetzt werden können. Dort werden zwei Sicherungsschaltungselemente 50 gegenüber Masse, das Überspannungsschutzelement 160 und das Temperatursicherungsschaltungselement 140 eingesetzt. Die Spannungsversorgung erfolgt über den Spannungseingang am Gerät 200. Sämtliche Schaltungselemente zum Sichern 50, 140, 160 liegen direkt an dem Versorgungsspannungseingang 200 an. Ein Mikroprozessor 250 liefert das Steuersignal für die Sicherungsschaltungselemente 50, deren Ausgang jeweils für die Spannungsversorgung einer Last 230b und eines Kondensators 210 sorgt.

Erkennt der Mikroprozessor einen kritischen Zustand der Schaltungsstrukturen, so veranlasst er die Sicherungsschaltungselemente 50, die Verbindung zur Last 230b oder zum Kondensator 210 zu unterbrechen. Gleichzeitig steuert der Mikroprozessor 250 auch die Last 230b über den Schalter 220b an.

Das Temperatursicherungsschaltungselement 140 versorgt an seinem Ausgang die Last 230a mit einer Spannung, und sichert diese in Abhängigkeit von einem Temperatursensorsignal 270 ab. Überschreitet die Temperatur an der Last 230a einen kritischen Wert, so verändert sich das Temperatursensorsignal 270 und veranlasst das Temperatursicherungsschaltungselement 140, die Versorgung der Last 230a zu unterbrechen. Gleichzeitig wird die Last 230a vom Mikroprozessor 250 über den Schalter 220a angesteuert.

Eine hochwertige Schaltungsstruktur 240 wird in dem Gerät, das die Ausführungsbeispiele der vorliegenden Erfindung einsetzt, durch das Überspannungsschutzelement 160 geschützt. Das Überspannungsschutzelement 160 erhält ein Spannungsteilereingangssignal 260, wodurch sichergestellt wird, dass die Spannung an der hochwertigen Schaltung 240 nie einen kritischen Wert überschreitet.

Fig. 7 zeigt eine Implementierung des in Fig. 1 dargestellten Ausführungsbeispiels gemäß der vorliegenden Erfindung. Hierbei handelt es sich um ein monolithisch auf einem Siliziumchip aufgebautes Schaltungselement, wobei das Schaltungselement auf dem Halbleitersubstrat 325 aufgebracht ist. Dargestellt ist hier eine Anordnung mit einem lateralen Thyristor als Schalter bzw. Auslöseelement 80. Das Unterbrechungselement 70 besteht hier aus einem Graben 280 bzw. einer Trench-Struktur, die zum Teil unter einer Leiterbahn 320 zwischen dem Eingang 60 und dem Ausgang 100 verläuft. Das Unterbrechungselement 70, das die Sicherungsstrecke bzw. den Abschnitt der Leiterbahn 320 zwischen dem Eingang 60 und der Katode 290 umfaßt, ist direkt neben der Kreuzungsstelle von der Leiterbahn 320 und der Metallisierung des Auslöseelements 80 bzw. Schalters, der hier als Thyristor ausgeführt ist, vollständig mit der Trench-Struktur bzw. dem Graben 280 untergraben.

Die beschriebene Anordnung umfasst also neben einem aktiven Bauelement, das hier als Auslöseelement 80 eingesetzt wird, eine Trench-Struktur 280 und eine Leiterbahn 320, die das Unterbrechungselement bzw. die Sicherungsstrecke bilden. Diese Anordnung kann entweder als diskretes Bauelement realisiert sein oder auch monolithisch auf dem Halbleiterchip integriert werden. Damit ist auch direkt auf einem Chip eine sichere Unterbrechung eines Strompfads realisierbar.

Im Auslösefall führt das Auslöselement 80 zu einem Strom zwischen den Anschlüssen 100 und der Anode 300, der sich im Bereich des Unterbrechungselements 70 dem Betriebsstrom zwischen den Anschlüssen 60 und 100 überlagert. Durch die Summe beider Ströme wird die Leiterbahn über dem Graben bzw. Trench 280 zum Schmelzen gebracht.

Die in der Querschnittsskizze eingezeichnete Trench- oder Grabenstruktur 280, die einen Hohlraum unterhalb der Leiterbahn erzeugt, erfüllt zum einen den Zweck, dass der Aktivierung der Auslösestruktur eine lokale Überhitzung genau oberhalb des Trenches 280 folgt, da eine in diesem Hohlraum befindliche Luft die entstehende Wärme sehr schlecht ableitet. Zum anderen wirkt der schmale Trench 280 wie eine Kapillare und sorgt damit für eine sichere mechanische Trennung der Leiterbahn durch Absaugen des flüssigen Materials in den Graben.

Das hier beschriebene Sicherungselement gemäß einem Ausführungsbeispiel der vorliegenden Erfindung kann beispielsweise auf Siliziumhalbleitermaterial hergestellt werden.

Es umfasst den Leistungsschalter, der das Gate 310, die Anode 300 und die Kathode 290 aufweist, und die Graben- bzw. Trench-Struktur 280, die als Teil des Unterbrechungselements das Unterbrechen der Leiterbahn 320 zwischen den Anschlüssen 60, 100 unterstützt. Das Unterbrechungselement 70 wird durch Herauslösen eines Stücks aus der Leiterbahn 320, das dann in den Graben 280 hineinfällt, realisiert.

Der Thyristor umfasst hier eine Struktur, die aus vier Zonen wechselnder Dotierung, n- bzw. p-Dotierung im Halbleiter bestehen. Die Dotierungsfolge ist von der jeweils verwendeten Technologie, das heißt der Dotierungsart des Substratmaterials abhängig. Verwendet man n-dotiertes Substratmaterial 320, so ist die Wanne unterhalb des Kathodenkontakts 290 und unterhalb der Gatemetallisierung 310 p-dotiert. Die Wannen unterhalb der Anodenkontakte 300 sind n-dotiert. Bei Verwendung von p-dotiertem Substratmaterial sind die zuvor genannten n- und p-Dotierungen zu tauschen.

Der Leistungsschalter kann aber auch als Bipolarstruktur, als eine Darlingtonschaltung, als MOSFET- oder IGBT-Struktur oder beliebige andere stromverstärkende Halbleiterstrukturen ausgeführt sein. Diese können als vertikale oder horizontale Bauelemente realisiert sein. Im Falle eines Leistungsschalters mit MOSFET-Gate kann dieses sowohl als p-Kanal oder auch als n-Kanaltransistor realisiert werden. Im Falle der Verwendung von Bipolartransistoren können diese als npn- oder pnp-Strukturen ausgeführt sein.

Der Trench 280 kann mit Hilfe eines anisotropen Ätzverfahrens, wie z. B. einem Trockenätzverfahren oder einem KOH-Ätzen hergestellt werden, das es ermöglicht, hohe Aspektverhältnisse zu erzeugen, um die Kapillarwirkung des Trenches bzw. Grabens zu erhalten. Der Trench kann entweder als ein einziger Trench ausgeführt sein oder als eine Anordnung mehrerer Trenches gleicher oder differierender Geometrie.

Die Grabenstruktur oder Trenchstruktur unterhalb eines Abschnitts der Leiterbahn, der als Sicherungsstrecke fungiert, bzw. im Bereich des Unterbrechungselements 70 können auch mittels isotroper Ätzverfahren, wie z. B. dem Naßchemischen Ätzen realisiert werden. Die Metallisierungsbahnen sind aus Aluminium oder anderen metallischen Schichten, wie z. B. Kupfer, Gold, Platin, Silber, Wolfram, Blei, Zink oder aus metallischen Legierungen oder sonstigen elektrisch leitfähigen Schichten.

Fig. 8a erläutert eine Implementierung eines Schaltungselements zum Sichern einer Lastschaltung gemäß einem Ausführungsbeispiel der vorliegenden Erfindung, wobei hier das Auslöseelement 80 durch einen Thyristor gebildet ist. Das Schaltungselement umfasst den Eingang 60, den Ausgang 100, die Anode des Thyristors 300 und das Gate 310 des Thyristors 330. Über das Gate 310 wird der Strom durch den Thyristor 330 gesteuert, wobei der Strom durch den Thyristor 330 sich mit dem Strom am Ausgang 100 überlagert.

Wenn nun der Strom durch den Thyristor 330 eine kritische Schwelle überschreitet, so beginnt der Strom durch das Unterbrechungselement 70 dieses zu erhitzen, solange bis es sich selbst zerstört.

In Fig. 8b ist eine Implementierung der in Fig. 8a dargestellten Schaltungsstruktur erläutert, inklusive der Kontakte 60, 100, 300, 310. Das Schaltungselement zum Sichern einer Lastschaltung kann bevorzugt auch als gehäuselose Ausführungsform oder als bond-drahtloses Chipscale package bzw. Chipscale-Gehäuse zum Einsatz kommen.

Die Kontaktierung 60, 100, 300, 310 erfolgt dann bevorzugt in einer Flip-Chip- oder BGA- bzw. Ball-grid-area-Technologie. In dem Ausführungsbeispiel der vorliegenden Erfindung sind die Anschlusspads bzw. Anschlusshöcker 60, 100, 300, 310 mit lötbaren Metalloberflächen versehen, so dass sich das Sicherungselement wie ein Flip-Chip-Bauelement direkt auf einen Schaltungsträger, wie z. B. eine Leiterplatte löten lässt.

Fig. 9a und Fig. 9b zeigen eine weitere Implementierung der in Fig. 8a gezeigten Schaltungsstruktur gemäß einem Ausführungsbeispiel der vorliegenden Erfindung. Aus Fig. 9a ist zu erkennen, dass die Schaltungsstruktur dieselbe Funktionalität umfasst wie die in Fig. 8a gezeigte Schaltung. Jedoch ist aus Fig. 9b zu erkennen, dass die Implementierung auf dem Halbleitersubstrat geändert worden ist. Statt eines einzigen Grabens 280, wie in Fig. 8b, sind in der Halbleiterstruktur gemäß Fig. 9b drei Gräben 280 unterhalb der Leiterbahn zwischen dem Eingang 60 und dem Ausgang 100 eingebracht.

Dies macht die Funktionalität des Unterbrechungselements 70 sicherer, da, falls das Durchtrennen der Leiterbahn oberhalb eines der drei Gräben 280 nicht korrekt erfolgen sollte, immer noch die beiden restlichen Gräben verbleiben, um die Leiterbahnen in der beabsichtigten Weise zu durchtrennen.

Fig. 10a zeigt ein weiteres Ausführungsbeispiel der vorliegenden Erfindung, das sich von dem Schaltungselement zur Sicherung einer Last in Fig. 8a dadurch unterscheidet, dass in Fig. 10a sämtliche Dotierungen gegenüber Fig. 8a vertauscht sind. Hierdurch ergibt sich auch die entgegengesetzte Polung des Thyristors 330, der wiederum an den Kontakten 100, 290, 310 angeschlossen ist.

Fig. 10b erläutert die Implementierung der in Fig. 10a gezeigten Schaltungsstruktur, wobei deutlich wird, dass die Dotierungsarten genau entgegengesetzt zu der Halbleiterstruktur von Fig. 8b sind.

Die Kathode 290 liegt dabei an der Versorgungsspannung, das heißt der Thyristor bzw. ein aktiver Schalter der die Funktion des Auslöseelements übernommen hat, liegen an der Versorgungsspannung, wie z. B. einer Fahrzeugbatterie an, wobei die Versorgungsspannung größer als die Spannung am Ausgang 100 ist.

Fig. 11a zeigt wieder dieselbe Schaltungsstruktur wie in Fig. 10a, wobei in Fig. 11b analog zu Fig. 9b wieder eine Mehrzahl an Gräben ausgeführt ist. Die Mehrzahl von Gräben in diesem Ausführungsbeispiel erhöht wiederum die Sicherheit des Auslösens des Unterbrechungselements 70.

Obige Ausführungsbeispiele haben gezeigt, dass es im Falle eines Defekts einzelner Komponenten einer elektronischen Schaltung das Ziel ist, weitergehende Schäden, wie beispielsweise Brandschäden durch eine sichere Unterbrechung des Strompfads zu verhindern. Obige Ausführungsbeispiele der vorliegenden Erfindung können in allen Anwendungsgebieten von elektronischen Schaltungen, insbesondere Schaltungen mit Betriebsspannungen im Niederspannungsbereich, das heißt kleiner 25 Volt, eingesetzt werden.

Da obige Ausführungsbeispiele ein Sicherungselement umfassen, das beispielsweise auf Siliziumbasis gefertigt werden kann, und in den Strompfad eingesetzt werden kann, und auch noch selbst oder fremd aktiviert durch den Stromfluss im Fehlerfall unterbricht, ist dieses System sowohl integriert als auch diskret realisierbar.

Obige Ausführungsbeipiele haben gezeigt, dass ein Schaltungselemt zum Sichern einer Lastschaltung bzw. ein Sicherungselement auf Halbleiterbasis mit integriertem elektronischen Auslösemechanismus ausgeführt sein kann, beispielsweise in diskretem Aufbau bestehend aus Sicherungselement und elektronischem Auslösemechanismus. Vorzugsweise kann dies auf Silizium als Substratmaterial, auf Siliziumcarbid als Substratmaterial oder Silizium-Germanium als Substratmaterial hergestellt sein.

Außerdem haben obige Ausführungsbeispiele der vorliegenden Erfindung dargestellt, dass der elektronische Auslösemechanismus z. B. als Thyristor, als Varistor, als MOSFET als IGBT oder als bipolarer Transistor ausgeführt ist.

In obigen Ausführungsbeispielen der vorliegenden Erfindung umfasst ein Sicherungselement eine stromleitfähige Verbindung, unter der sich eine oder mehrere Aussparungen im Substratmaterial befinden. Diese Aussparungen können in obigen Ausführungsbeispielen mit luftgefüllte Hohlräume aufweisen, oder mit einem Explosivstoff oder einem Blähstoff gefüllt sein.

Obige Ausführungsbeispiele haben gezeigt, dass die Aussparungen vorzugsweise hohe Aspektverhältnisse aufweisen, vorteilhafterweise wie Kapilaren wirken und durch anisotrope Ätzvorgänge, Trockenätzvorgänge oder nasschemische Ätzvorgänge erzeugt sind. Vorteilhaft ist auch, wenn diese Aussparungen eine schlechte Wärmeleitfähigkeit besitzen.

In obigen Ausführungsbeispielen der vorliegenden Erfindung sind die Schaltungselemente zum Sichern einer Lastschaltung vorteilhafterweise kompatibel zu Standard SMD-Gehäusen und vorzugsweise mit Standard SMT-Prozessen auf Schaltungsträgern montierbar.

Die Ausführungsbeispiele der vorliegenden Erfindung können als Schaltungselemente ausgeführt sein, die einen Thyristor, bei dem bei einer definierten Temperatur ein Überkopfzünden auftritt oder einen elektrischen Schalter, der bei einer definierten Temperatur in den Durchlaß schaltet, umfassen.

In obigen Ausführungsbeispielen der vorliegenden Erfindung kann ein Temperatursensor in dem Schaltungselement zum Sichern der Lastschaltung einen Crowbar-Schalter bei einer definierten Temperatur zünden, eine Spannungserfassung bei Erreichen einer Spannungsschwelle den Crowbar-Schalter zünden oder eine Laststromerfassung bei Erreichen eines Stromschwellwerts den Crowbar-Schalter zünden.

## Patentansprüche

1. Schaltungselement (50, 140, 160, 180) zum Sichern einer Lastschaltung mit folgenden Merkmalen:
einem Signaleingang (60) zum Anlegen eines Signals;
einem Signalausgang (100);
einem Signalpfad (320), der den Signaleingang (60) mit dem Signalausgang (100) verbindet und über eine Leiterbahn (320) führt, die auf einer Hauptoberfläche eines Halbleitersubstrats (325) angeordnet ist und an einen ersten wärmeableitenden Bereich und einen zweiten wärmeableitenden Bereich angrenzt, wobei die Wärmeableitung des zweiten wärmeableitenden Bereichs schlechter als die Wärmeableitung des ersten wärmeableitenden Bereichs ist,
wobei der zweite wärmeableitende Bereich einen Grabenbereich in dem Halbleitersubstrat (325) umfasst, der derart ausgebildet ist, dass durch die schlechte Wärmeableitung desselben durch eine lokale Erhitzung oberhalb des Grabenbereichs die Leiterbahn (320) über dem Grabenbereich schmelzbar ist, und
wobei der Grabenbereich einen Hohlraum (280) unterhalb der Leiterbahn definiert, dessen Abmessung in einer Richtung senkrecht zu der Hauptoberfläche des Halbleitersubstrats (325), auf der die Leiterbahn (320) angeordnet ist, größer ist als dessen Abmessung in einer Richtung der Erstreckung der Leiterbahn (320), so dass der Hohlraum als eine Kapillare zum Absaugen des geschmolzenen Leiterbahnmaterials wirkt; und
einer Unterbrechungseinrichtung (70) zum irreversiblen Unterbrechen des Signalpfads (320) auf den Empfang eines Steuersignals (90, 260, 270) an derselben.

2. Schaltungselement (50, 120, 140, 160, 180) zum Sichern einer Lastschaltung gemäß Anspruch 1, bei dem die Unterbrechungseinrichtung (70) ein Sicherungselement aufweist, das einen Signalpfadabschnitt umfasst, der bei einem Strom durch denselben, der einen vorbestimmten Strom überschreitet, irreversibel unterbrochen wird, eine Überwachungsschaltung (150; 170; 190) zum Detektieren eines Fehlerzustands auf der Grundlage eines Stroms durch den Signalpfadabschnitt und zum Erzeugen eines Steuersignals basierend auf dem detektierten Fehlerzustand und einen elektrischen Auslösemechanismus (80) aufweist, der auf einen Empfang des Steuersignals hin den Strom durch den Signalpfad (320) bewirkt, der größer als der vorbestimmte Strom ist

3. Schaltungselement (50, 120, 140, 160, 180) zum Sichern einer Lastschaltung gemäß einem der Ansprüche 1 oder 2, bei dem die Überwachungsschaltung eine Spannungsteilerschaltung (170) aufweist.

4. Schaltungselement (50, 120, 140, 160, 180) zum Sichern einer Lastschaltung gemäß Anspruch 3, bei der an einem Eingang der Spannungsteilerschaltung (170) ein Spannungsteilereingangsignal anliegt, das von einem Signal an dem Signalausgang (100) abhängt.

5. Schaltungselement (50, 120, 140, 160, 180) zum Sichern einer Lastschaltung gemäß einem der Ansprüche 2 bis 4, bei dem die Überwachungsschaltung einen Temperatursensor (150) aufweist.

6. Schaltungselement (50, 120, 140, 160, 180) zum Sichern einer Lastschaltung gemäß einem der Ansprüche 2 bis 5, bei dem die Überwachungsschaltung eine Steuerschaltung (250) mit einem Rechnerkern aufweist.

7. Schaltungselement (50, 120, 140, 160, 180) zum Sichern einer Lastschaltung gemäß einem der Ansprüche 2 bis 6, bei dem die Überwachungsschaltung eine Strommessschaltung (190), die den Strom über den Signalpfad bestimmt, aufweist.

8. Schaltungselement (50, 120, 140, 160, 180) zum Sichern einer Lastschaltung gemäß einem der Ansprüche 1 bis 7, bei dem die Unterbrechungseinrichtung (70) einen Feldeffekttransistor, einen Bipolartransistor, einen Thyristor, einen Varistor oder eine IGBT-Struktur umfasst.

9. Schaltungselement (50, 120, 140, 160, 180) zum Sichern einer Lastschaltung gemäß einem der Ansprüche 1 bis 8, bei dem die Leiterbahn (320) in einem Unterbrechungsbereich (70), der sich in der Nähe des schlechten wärmeableitenden Bereichs befindet, so ausgebildet ist, dass es sich beim Unterbrechen des Signalpfads durch einen von der Unterbrechungseinrichtung gesteuerten Auslösestroms selbst erwärmt, bis der Signalpfad (320) durch die in Folge der Erwärmung entstehende Selbstzerstörung der Leiterbahn (320) unterbrochen ist.

10. Chip, der ein Schaltungselement (50,120,140,160, 180) gemäß einem der Ansprüche 1 bis 9 umfasst.

## Claims

1. Circuit element (50, 140, 160, 180) for protecting a load circuit, comprising:
a signal input (60) for applying a signal;
a signal output (100);
a signal path (320) connecting the signal input (60) to the signal output (100) and leading via a trace (320) arranged on a main surface of a semiconductor substrate (325) and bordering on a first heat-dissipating region and a second heat-dissipating region, wherein the heat dissipation of the second heat-dissipating region is worse than the heat dissipation of the first heat-dissipating region,
wherein the second heat-dissipating region includes a trench region in the semiconductor substrate (325), which is formed such that the trace (320) is meltable over the trench region by local heating above the trench region by the poor heat dissipation thereof, and
wherein the trench region defines a cavity (280) below the trace, the dimension of which in a direction perpendicular to the main surface of the semiconductor substrate (325), on which the trace (320) is arranged, is greater than its dimension in a direction of the extension of the trace (320), so that the cavity acts as a capillary for sucking off the molten trace material; and
an interruption means (70) for irreversibly interrupting the signal path (320) upon the reception of a control signal (90, 260, 270) at the same.

2. Circuit element (50, 120, 140, 160, 180) for protecting a load circuit of claim 1, wherein the interruption means (70) comprises a protection including a signal path portion that is irreversibly interrupted at a current through the same which exceeds a predetermined current, a monitoring circuit (150; 170; 190) for detecting a fault state on the basis of a current through the signal path portion and for generating a control signal based on the detected fault state, and an electric trigger mechanism (80), which causes, upon reception of the control signal, the current through the signal path (320) which exceeds the predetermined current.

3. Circuit element (50, 120, 140, 160, 180) for protecting a load circuit of one of claims 1 or 2, wherein the monitoring circuit comprises a voltage divider circuit (170).

4. Circuit element (50, 120, 140, 160, 180) for protecting a load circuit of claim 3, wherein a voltage divider input signal dependent on a signal at the signal output (100) is present at an input of the voltage divider circuit (170).

5. Circuit element (50, 120, 140, 160, 180) for protecting a load circuit of one of claims 2 to 4, wherein the monitoring circuit comprises a temperature sensor (150).

6. Circuit element (50, 120, 140, 160, 180) for protecting a load circuit of one of claims 2 to 5, wherein the monitoring circuit comprises a control circuit (250) with a computer core.

7. Circuit element (50, 120, 140, 160, 180) for protecting a load circuit of one of claims 2 to 6, wherein the monitoring circuit comprises a current measurement circuit (190) determining the current across the signal path.

8. Circuit element (50, 120, 140, 160, 180) for protecting a load circuit of one of claims 1 to 7, wherein the interruption means (70) includes a field-effect transistor, a bipolar transistor, a thyristor, a varistor, or an IGBT structure.

9. Circuit element (50, 120, 140, 160, 180) for protecting a load circuit of one of claims 1 to 8, wherein the trace (320) in an interruption region (70) in the proximity of the poor thermally conducting region is formed so that it heats up by itself upon interrupting the signal path by a trigger current controlled by the interruption means until the signal path (320) is interrupted by the self-destruction of the trace (320) arising as a result of the heating.

10. Chip including a circuit element (50, 120, 140, 160, 180) of one of claims 1 to 9.

## Revendications

1. Elément interrupteur (50, 140, 160, 180) pour protéger un circuit comprenant une charge, aux caractéristiques suivantes:
une entrée de signal (60) pour appliquer un signal;
une sortie de signal (100);
un trajet de signal (320) qui relie l'entrée de signal (60) à la sortie de signal (100) et qui passe par une piste conductrice (320) qui est disposée sur une surface principale d'un substrat semi-conducteur (325) et est adjacente à une première zone de dissipation de chaleur et une deuxième zone de dissipation de chaleur, la dissipation de chaleur de la deuxième zone de dissipation de chaleur étant plus mauvaise que la dissipation de chaleur de la première zone de dissipation de chaleur,
dans lequel la deuxième zone de dissipation de chaleur comporte une zone de fossé dans le substrat semi-conducteur (325) qui est conçue de sorte que par la mauvaise dissipation de chaleur de cette dernière puisse fondre par un échauffement local au-dessus de la zone de fossé la piste conductrice (320) au-dessus de la zone de fossé, et
dans lequel la zone de fossé définit une cavité (280) au-dessous de la piste conductrice dont la dimension dans une direction perpendiculaire à la surface principale du substrat semi-conducteur (325) sur laquelle est disposée la piste conductrice (320) est plus grande que sa dimension dans une direction de l'extension de la piste conductrice (320), de sorte que la cavité agisse comme un capillaire destiné à aspirer le matériau conducteur en fusion; et
un moyen d'interruption (70) destiné à interrompre de manière irréversible le trajet de signal (320) à la réception d'un signal de commande (90, 260, 270) à ce dernier.

2. Elément interrupteur (50, 120, 140, 160, 180) pour protéger un circuit comprenant une charge selon la revendication 1, dans lequel le moyen d'interruption (70) présente un élément de protection qui comporte un segment de trajet de signal qui est interrompu de manière irréversible lors du passage à travers ce dernier d'un courant qui excède un courant prédéterminé, un circuit de surveillance (150; 170; 190) destiné à détecter un état de défaut sur base d'un courant à travers le segment de trajet de signal et à générer un signal de commande sur base de l'état de défaut détecté, et un mécanisme de déclenchement électrique (80) qui provoque, à un réception du signal de commande, le passage du courant à travers le trajet de signal (320) qui est supérieur au courant prédéterminé.

3. Elément interrupteur (50, 120, 140, 160, 180) pour protéger un circuit comprenant une charge selon l'une des revendications 1 ou 2, dans lequel le circuit de surveillance présente un circuit diviseur de tension (170).

4. Elément interrupteur (50, 120, 140, 160, 180) pour protéger un circuit comprenant une charge selon la revendication 3, dans lequel est présent à une entrée du circuit diviseur de tension (170) un signal d'entrée de division de tension qui dépend d'un signal à la sortie de signal (100).

5. Elément interrupteur (50, 120, 140, 160, 180) pour protéger un circuit comprenant une charge selon l'une des revendications 2 à 4, dans lequel le circuit de surveillance présente un capteur de température (150).

6. Elément interrupteur (50, 120, 140, 160, 180) pour protéger un circuit comprenant une charge selon l'une des revendications 2 à 5, dans lequel le circuit de surveillance présente un circuit de commande (250) avec un noyau processeur.

7. Elément interrupteur (50, 120, 140, 160, 180) pour protéger un circuit comprenant une charge selon l'une des revendications 2 à 6, dans lequel le circuit de surveillance présente un circuit de mesure de courant (190) qui détermine le courant traversant le trajet de signal.

8. Elément interrupteur (50, 120, 140, 160, 180) pour protéger un circuit comprenant une charge selon l'une des revendications 1 à 7, dans lequel le moyen d'interruption (70) présente un transistor à effet de champ, un transistor bipolaire, un thyristor, une varistance ou une structure IGBT.

9. Elément interrupteur (50, 120, 140, 160, 180) pour protéger un circuit comprenant une charge selon l'une des revendications 1 à 8, dans lequel la piste conductrice (320) est réalisée, dans une zone d'interruption (70) qui se trouve à proximité de la zone à mauvaise dissipation de chaleur, de sorte qu'elle se réchauffe lors de l'interruption du trajet de signal par un courant de déclenchement commandé par le moyen d'interruption lui-même jusqu'à ce que le trajet de signal (320) soit interrompu par l'autodestruction de la piste conductrice (320) produite à la suite de l'échauffement.

10. Puce qui comporte un élément de circuit (50, 120, 140, 160, 180) selon l'une des revendications 1 à 9.
